# EUROPÄISCHE PATENTANMELDUNG

(11) **EP 1 811 617 A1**
(43) Veröffentlichungstag der Anmeldung: **25.07.2007**
(21) Anmeldenummer: 06008616.2
(22) Anmeldetag: 26.04.2006
(51) Int. Cl.: H01S 5/02, H01S 5/40, H01S 5/024

(54) **Träger für eine vertikale Anordnung von Laserdiodenbarren mit Anschlag**

(30) Priorität: 18.01.2006 DE 102006002876
(71) Anmelder: JENOPTIK Laserdiode GmbH, 07745 Jena (DE)
(72) Erfinder: Lorenzen, Dr. Dirk, 07745 Jena (DE); Hennig, Petra, 07646 Mörsdorf (DE); Schröder, Matthias, 07646 Stadtroda (DE); Röllig, Ulrich, 07743 Jena (DE)
(74) Vertreter: Bertram, Helmut

(57) **Zusammenfassung**

Eine in der Leistung skalierbare Laserstrahlungsquelle ist derart zu gestalten, dass Diodenlaserbarren mit geringem Fertigungsaufwand äquidistant gestapelt und spannungsarm auf einem Träger aufgebracht werden können.

Die Laserstrahlungsquelle enthält einen vertikalen Stapel von Diodenlaserbarren (1), die beidseitig über elektrisch leitende Substratschichten (2,3) kontaktiert sind und einen mehrschichtigen Träger (4), der aus einer oberen und einer unteren metallischen Schicht (5,6) besteht, die durch mindestens eine elektrisch isolierende Schicht (7) aus nichtmetallischem Material getrennt sind. Mindestens die obere oder die untere metallische Schicht ist in nebeneinander und mit einem Abstand zueinander angeordnete metallische Schichtenbereiche (8) gegliedert. Gegenpolige Substratschichten benachbarter Diodenlaserbarren (1) sind auf gemeinsamen Schichtenbereichen einer metallischen Schicht (8) aufgebracht.
Kollimatorlinsen (11) dienen der Kollimation der von den Diodenlastbaren (1) emittierten Strahlung.

## Beschreibung

Zum Pumpen von Festkörperlasern, für die industrielle Laser-Materialbearbeitung und auch in der Medizintechnik werden üblicherweise Hochleistungsdiodenlaser in Form von Diodenlaserbarren verwendet, die durch Stapeln zu zweidimensional emittierenden Flächen mit einer erhöhten Strahlungsleistung aufgebaut werden können.

Von zahlreichen Vorschlägen für so genannte Stacks, beschreibt die US 5 923 692 A ein Hochleistungsdiodenlaserarray aus vertikal gestapelten und über elektrisch leitende Substratschichten kontaktierte Diodenlaserbarren. Über eine der Substratschichten besteht ein thermischer Kontakt zu einer thermisch leitfähigen und elektrisch isolierenden Trägerplatte, die mit einer Wärmesenke verbunden ist. Die Diodenlaserbarren sind in Serie geschaltet, indem die elektrisch leitenden Substratschichten benachbarter Diodenlaserbarren direkt miteinander verbunden sind.

Das hat einerseits den Nachteil, dass thermo-mechanische Spannungen auftreten können, da die Diodenlaserbarren sowohl untereinander als auch mit der Trägerplatte verbunden sind. Andererseits führen Dickenschwankungen bei den Diodenlaserbarren und den elektrisch leitenden Substratschichten zu Abstandsschwankungen zwischen den Diodenlaserbarren.

Es ist deshalb Aufgabe der Erfindung, eine in der Leistung skalierbare Laserstrahlungsquelle derart zu gestalten, dass die Diodenlaserbarren mit geringem Fertigungsaufwand äquidistant gestapelt und spannungsarm auf einem Träger aufgebracht werden können.

Erfindungsgemäß wird die Aufgabe durch eine Laserstrahlungsquelle gelöst, die
- einen vertikalen Stapel von Diodenlaserbarren, die beidseitig über Substratschichten aus elektrisch leitendem Material kontaktiert sind und
- einen mehrschichtigen Träger enthält, der aus einer oberen und einer unteren metallischen Schicht besteht, die durch mindestens eine elektrisch isolierende Schicht aus nichtmetallischem Material getrennt sind, wobei
- mindestens die obere oder die untere metallische Schicht in nebeneinander und mit einem Abstand zueinander angeordnete metallische Schichtenbereiche gegliedert ist, und wobei
- gegenpolige Substratschichten benachbarter Diodenlaserbarren auf gemeinsamen Schichtenbereichen einer metallischen Schicht aufgebracht sind.

Gemäß der Erfindung steht jeder Diodenlaserbarren über die p- und n-seitigen Substratschichten mit den elektrisch leitenden Schichtenbereichen im elektrischen und somit mit dem Träger im thermischen Kontakt. Aufgrund der Nutzung, gemeinsamer Schichtenbereiche für gegenpolige Substratschichten benachbarter Diodenlaserbarren wird der Stromfluss bei der Serienschaltung über die metallischen Schichtenbereiche des Trägers geführt.

Besonders vorteilhaft kann deshalb zwischen den gegenpoligen Substratschichten benachbarter Diodenlaserbarren ein Spalt freigelassen werden, wodurch sich die Diodenlaserbarren hochgenau äquidistant positionieren lassen, indem auf einfache Weise ein Ausgleich von Dickentoleranzen bei den Diodenlaserbarren und den Substratschichten vorgenommen werden kann.

Da die sandwichartig aufgebauten Komponenten aus Diodenlaserbarren und Substratschichten einzeln und unabhängig voneinander auf dem Träger aufgebracht werden können, lässt sich ein spannungsarmer Aufbau gestalten.

Zur Herstellung des Trägers besonders geeignet ist die DCB-Technologie, da ein derartig gefertigter Aufbau einerseits eine gute Wärmeleitfähigkeit gewährleistet, andererseits aber auch durch ausreichende Schichtdicken der aus Kupfer bestehenden Oberflächenschichten den Durchfluss von einigen Hundert Ampere zulässt.

Weitere Vorteile bestehen darin, dass mit der Erfindung eine leichte und wenige Komponenten aufweisende Laserstrahlungsquelle bereitgestellt werden kann, die keine Verschraubungen und lösbaren mechanischen Teile aufweist und die frei ist von ausgasenden Materialien. Zudem lässt sich mit dem vorgeschlagenen Konzept eine einfache Skalierung realisieren.

In vorteilhafter Ausgestaltung kann der Träger mit einem zwischen nichtmetallischen Schichten angeordneten Mikrokühler ausgestattet sein, der Kanäle für ein Kühlmedium aufweist, für das ein Zufuhrkanal und ein Ableitungskanal im Boden des Trägers vorgesehen sind.

Die Substratschichten, die den vertikalen Stapel von Diodenlaserbarren begrenzen, sind jeweils allein auf einen Schichtenbereich aufgelötet, wobei an jeden Schichtenbereich ein elektrisches Kontaktelement zur Stromzufuhr geführt ist. Vorteilhaft wirkt sich hierbei aus, wenn die Schichtenbereiche, auf denen die den vertikalen Stapel von Diodenlaserbarren begrenzenden Substratschichten aufgelötet sind, im elektrischen Kontakt mit jeweils einem Schichtenbereich auf der gegenüberliegenden Seite des Trägers stehen, auf der die elektrischen Kontaktelemente an dem Schichtenbereich angebracht sind - zum Beispiel über eine Durchkontaktierung in der elektrisch isolierenden Schicht.

Weitere vorteilhafte Ausgestaltungen und Weiterbildungen der erfindungsgemäßen Laserstrahlungsquelle ergeben sich aus den abhängigen Ansprüchen.

Die Erfindung soll nachstehend anhand der schematischen Zeichnung näher erläutert werden. Es zeigen:
- Fig. 1: eine Draufsicht auf eine erfindungsgemäße Laserstrahlungsquelle
- Fig. 2: die Unterseite eines Trägers für einen Diodenlaserbarrenstapel gemäß der Erfindung
- Fig. 3: eine Seitenansicht der Laserstrahlungsquelle gemäß Fig. 1
- Fig. 4: einen Ausschnitt X aus Fig. 3
- Fig. 5: eine Durchkontaktierung zwischen Schichtenbereichen auf der Ober- und der Unterseite des Trägers in einen Ausschnitt Y aus Fig. 3
- Fig. 6: die Positionierung von Kollimatorlinsen vor jeden Diodenlaserbarren des Diodenlaserstapels

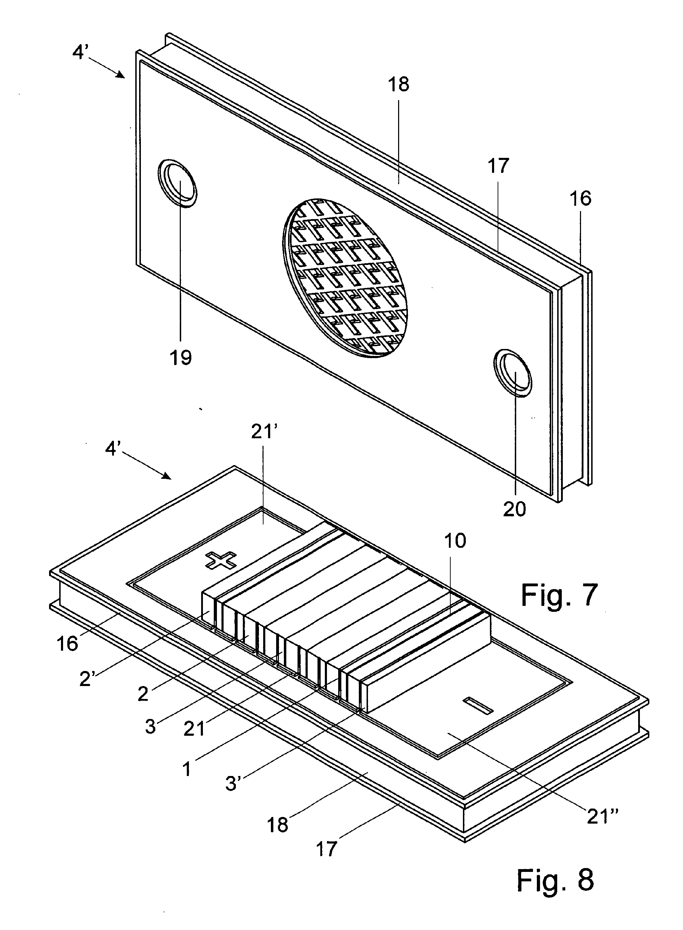

- Fig. 7: einen als Mikrokühler ausgebildeten Träger für den Diodenlaserstapel
- Fig. 8: den Träger gemäß Fig. 7 mit aufgebrachtem Diodenlaserstapel

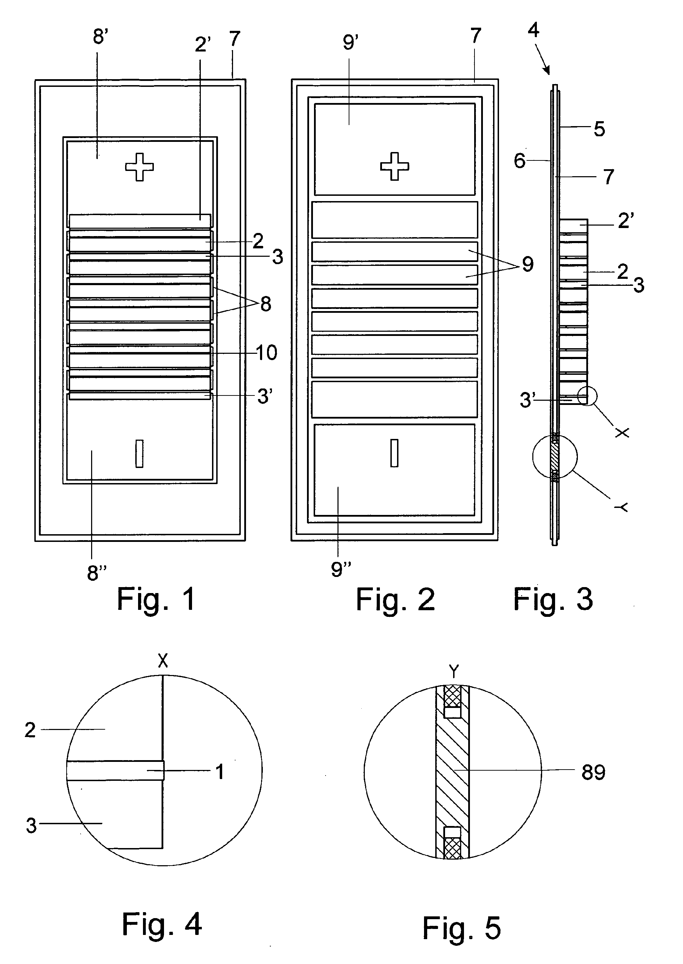

Bei der in Fig. 1 dargestellten Laserstrahlungsquelle sind Diodenlaserbarren 1 (z. B. aus GaAs) durch Substratschichten 2, 3 aus elektrisch leitendem Material (z. B. mit einem ähnlichen thermischen Ausdehnungskoeffizienten wie das Material des Diodenlaserbarrens wie Kupfer-Wolfram) p- und n-seitig mittels Hartlot (z. B. eutektisches Gold-Zinn Au80Sn20) verbunden und damit kontaktiert und auf einem zur Stromzufuhr und zur Wärmeabfuhr dienenden Träger 4 aufgebracht.

Die Dicke der Substratschichten 2, 3, d. h. deren Abmessung in Stapelrichtung der Diodenlaserbarren 1 ist vergleichbar mit der Resonatorlänge der Diodenlaserbarren 1. In bevorzugten Ausführungen sollte die Dicke der p-seitigen Substratschichten 2 das 0,5- bis 1-fache und die der n-seitigen Substratschichten 3 das 0,25- bis 0,5-fache der Resonatorlänge der Diodenlaserbarren 1 betragen. Durch unterschiedliche Dicken der n-seitigen Substratschichten 3 kann eine Abstandsänderung (Pitch) zwischen den Diodenlaserbarren 1 vorgenommen werden.

Die Länge der Substratschichten 2, 3 über den Schichtenbereichen 8 übersteigt die Resonatorlänge, ist jedoch aus Gründen der thermischen Weglänge vorzugsweise immer kleiner als das Doppelte der Resonatorlänge.

Der als dünne Platte ausgebildete Träger 4, der bevorzugt nach dem DCB-Verfahren (direct copper bonding) hergestellt ist, weist auf der Ober- und Unterseite metallische Schichten 5, 6 aus Kupfer auf, die durch mindestens eine nichtmetallische Schicht 7 aus einer Aluminiumnitrid-Keramik getrennt sind.

Von Bedeutung ist, dass die Summe der Dicken der metallischen Schichten und die Summe der Dicken der nichtmetallischen Schichten in einem bestimmten Verhältnis stehen, um einen mittleren thermischen Ausdehnungskoeffizienten in der Montageebene zu erzielen, der näherungsweise dem der getragenen Elemente entspricht.

Im besonderen Fall des im DCB-Verfahren aufgetragenen Kupfers, das durch dieses Verfahren eine wohldefinierte Härte erhält, sollte die Summe der Dicken der metallischen Schichten doppelt so groß sein wie die Summe der Dicken der nichtmetallischen Schichten aus Aluminiumnitrid. Geeignete Kupferschichtdicken liegen in einem Bereich von 0,1 mm bis 1 mm bei dementsprechender Keramikschichtdicke und gewährleisten durch ihre Steifigkeit eine hohe Ebenheit des Trägers 4.

Bei anderen Härtegraden des Kupfers ist ein anderes Dickenverhältnis erforderlich, um einen gewünschten Ausdehnungskoeffizienten für den Träger 4 zu erhalten. Für Vickershärten des Kupfers von HV60 bis HV120 sind Dickenverhältnisse zu wählen, bei denen die Summe der Dicken der metallischen Schichten zu der Summe der Dicken der nichtmetallischen Schichten Verhältnisse von 1,5:1 bis 2,0:1 annimmt.

Auf der Seite des Trägers 4, die zur Aufnahme der Diodenlaserbarren 1 vorgesehen ist, ist die metallische Schicht, hier die Schicht 5 der Oberseite, in Schichtenbereiche 8 unterteilt, die als elektrische Leitungsbahnen parallel zueinander und mit einem Abstand nebeneinander angeordnete Streifen bilden. Auf die Schichtenbereiche 8 werden die Substratschichten 2, 3 aus elektrisch leitendem Material bevorzugt mit einem Hartlot, wie z. B. eutektisches Gold-Zinn Au80Sn20, aufgelötet, wodurch über beide Substratschichten 2, 3 sowohl ein elektrischer Kontakt zu den Schichtenbereichen 8 als auch ein thermischer Kontakt zu dem Träger 4 hergestellt wird.

Gemäß der Erfindung werden die Substratschichten 2, 3 mit den Schichtenbereichen 8 derart verbunden, dass gegenpolige Substratschichten 2, 3 benachbarter Diodenlaserbarren 1 auf gemeinsamen Schichtenbereichen 8 aufgebracht sind.

Zwischen den gegenpoligen Substratschichten 2, 3 kann besonders vorteilhaft für eine äquidistante Abstandseinstellung zwischen den Diodenlaserbarren 1 ein Spalt 10 freigelassen werden, da der Stromfluss vom n-Kontakt eines ersten Diodenlaserbarrens 1 zum p-Kontakt eines benachbarten zweiten Diodenlaserbarrens 1 gemäß der Erfindung über den Träger 4, insbesondere über jeweils einen gemeinsamen Schichtenbereich 8 geführt ist.

Die beiden außen liegenden Substratschichten des Diodenlaserbarrenstapels, eine p-kontaktseitige Substratschicht 2' und eine n-kontaktseitige Substratschicht 3', sind jeweils allein auf einen Schichtenbereich 8' und 8" aufgelötet, wobei an jeden Schichtenbereich 8', 8" ein nicht dargestelltes elektrisches Kontaktelement zur Stromzufuhr geführt ist.

Bevorzugt erfolgt die Stromzufuhr dadurch, dass von den Schichtenbereichen 8', 8" eine elektrische Durchkontaktierung 89, dargestellt in Fig. 5, durch die nichtmetallische Schicht 7 zu einem Schichtenbereich 9', 9" auf der gegenüberliegenden Seite des Trägers 4 vorhanden ist. Die Seite des Trägers 4 mit den Diodenlaserbarren 1 kann dadurch von relativ großen elektrischen Kontaktelementen, die hinderlich auf die Strahlausbreitung wirken können, freigehalten werden, wenn die elektrischen Kontaktelemente an der gegenüberliegenden Seite angebracht werden.

Um einer möglichen Verkrümmung des Trägers 4 im Fügeprozess der Schichten 5, 6 und 7 oder bei der Montage der verbundenen Elemente 1, 2 und 3 auf den Träger 4 vorzubeugen, ist bevorzugt auch die metallische Schicht 6 auf der Unterseite des Trägers 4 in Schichtenbereiche 9 unterteilt, wobei die Schichtenbereiche 9 den Schichtenbereichen 8 gegenüberliegen oder entsprechend Fig. 2 zu diesen versetzt angeordnet sein können.

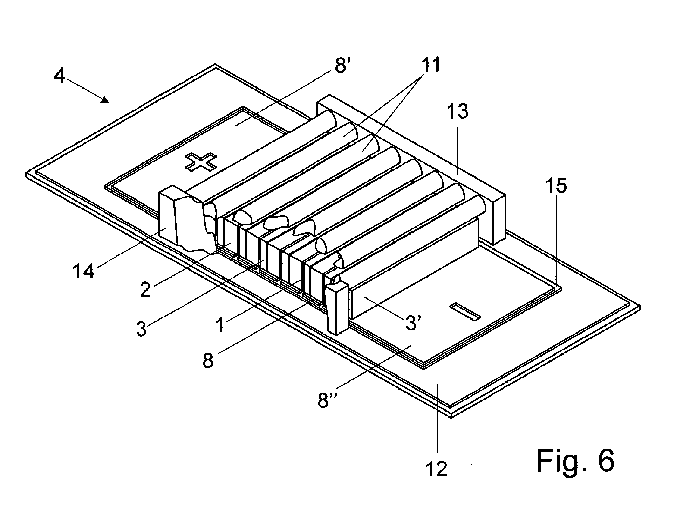

Je nach Dicke der n-seitigen Substratschichten 3 lässt sich der nötige Bauraum schaffen, um vor jeden Diodenlaserbarren 1 Kollimatorlinsen 11 gemäß Fig. 6 anordnen zu können.
Besonders vorteilhaft eignen sich seitlich zu den Diodenlaserbarren 1 positionierte und auf dem Träger 4 auf einen Schichtenbereich 12 der metallischen Schicht 5 aufgelötete Brückenelemente 13, 14, an denen die Kollimatorlinsen 11 z. B. durch laserinitiierte Lötverbindungen mit niedriger schmelzenden Loten, wie z. B. zinnreiches eutektisches Zinn-Silber-Kupfer (SAC-Lot), befestigt sind.
Der Schichtenbereich 12 ist durch einen umlaufenden durchgängigen Spalt 15 elektrisch von den übrigen Schichtenbereichen 8, 8' und 8" der metallischen Schicht der Oberseite getrennt.

In einer weiteren Ausführung der Erfindung kann anstelle des plattenförmigen Trägers 4 auch ein Träger 4' zur Anwendung kommen, der mit einem, zwischen zwei nichtmetallischen Schichten 16, 17 aus Aluminiumnitrid-Keramikschichten angeordneten Mikrokühler 18 ausgestattet ist. Der Mikrokühler 18 wird durch mehrere strukturierte Metallschichten gebildet, die durch ihre Strukturierung dreidimensional sich verzweigende Kanäle für ein Kühlmedium bilden, für das ein Zufuhrkanal 19 und ein Ableitungskanal 20 im Boden des Träger 4' vorgesehen sind.

Analog dem Träger 4 ist auch der Träger 4' auf der Ober- und der Unterseite mit metallischen Schichten aus Kupfer beschichtet, wobei die Kupferschicht der Oberseite eine Strukturierung entsprechend dem Träger 4 aufweist, so dass über Schichtenbereiche 21, 21' und 21" die elektrische und thermische Verbindung zu den p- und n-seitigen Substratschichten 2, 3 hergestellt werden kann. An die Schichtenbereiche 21', 21" sind nicht dargestellte elektrische Kontaktelemente geführt.

## Patentansprüche

1. Laserstrahlungsquelle, enthaltend
- einen vertikalen Stapel von Diodenlaserbarren (1), die beidseitig über Substratschichten (2, 3) aus elektrisch leitendem Material kontaktiert sind und
- einen mehrschichtigen Träger (4, 4'), bestehend aus einer oberen und einer unteren metallischen Schicht (5, 6), die durch mindestens eine elektrisch isolierende Schicht (7) aus nichtmetallischem Material getrennt sind, wobei
- mindestens die obere oder die untere metallische Schicht (5, 6) in nebeneinander und mit einem Abstand zueinander angeordnete metallische Schichtenbereiche (8, 8', 8", 9, 9', 9") gegliedert ist, und wobei
- gegenpolige Substratschichten (2, 3) benachbarter Diodenlaserbarren (1) auf gemeinsamen Schichtenbereichen (8, 9) einer metallischen Schicht aufgebracht sind.

2. Laserstrahlungsquelle nach Anspruch 1, bei der zwischen den gegenpoligen Substratschichten (2, 3) benachbarter Diodenlaserbarren (1) ein Spalt (10) freigelassen ist.

3. Laserstrahlungsquelle nach Anspruch 2, bei der die obere und die untere metallische Schicht (5, 6) in nebeneinander und mit einem Abstand zueinander angeordnete metallische Schichtenbereiche (8, 8', 8", 9, 9', 9") gegliedert ist.

4. Laserstrahlungsquelle nach Anspruch 3, bei der die Schichtenbereiche (8, 8', 8") der oberen metallischen Schicht (5) und die Schichtenbereiche (9, 9', 9") der unteren metallischen Schicht (6) deckungsgleich zueinander angeordnet sind.

5. Laserstrahlungsquelle nach Anspruch 3, bei der die Schichtenbereiche (8, 8', 8") der oberen metallischen Schicht (5) und die Schichtenbereiche (9, 9', 9") unteren metallischen Schicht (6) versetzt zueinander angeordnet sind.

6. Laserstrahlungsquelle nach Anspruch 4 oder 5, bei der Substratschichten (2', 3'), die den vertikalen Stapel von Diodenlaserbarren (1) begrenzen, jeweils allein auf einen Schichtenbereich (8', 8") aufgelötet sind, wobei an jeden Schichtenbereich (8', 8") ein elektrisches Kontaktelement zur Stromzufuhr geführt ist.

7. Laserstrahlungsquelle nach Anspruch 6, bei der die Schichtenbereiche (8', 8"), auf denen die Substratschichten (2, 3) aufgelötet sind, die den vertikalen Stapel von Diodenlaserbarren (1) begrenzen, im elektrischen Kontakt mit jeweils einem Schichtenbereich (9', 9") auf der gegenüberliegenden Seite des Trägers 4 stehen, auf der die elektrischen Kontaktelemente an den Schichtenbereichen (9', 9") angebracht sind.

8. Laserstrahlungsquelle nach einem der Ansprüche 1 bis 7, bei der die Abmessungen der p-seitigen Substratschichten (2) in Richtung senkrecht zu den Kontaktflächen des Diodenlaserbarren (1) das 0,5- bis 1-fache und die der n-seitigen Substratschichten (3) das 0,25- bis 0,5-fache der Resonatorlänge der Diodenlaserbarren (1) betragen.

9. Laserstrahlungsquelle nach einem der Ansprüche 1 bis 8, bei der die Abmessungen der Substratschichten (2, 3) in Lichtemissionsrichtung über den Schichtenbereichen (8) die Resonatorlänge der Diodenlaserbarren (1) übersteigen, jedoch kleiner sind als das Doppelte der Resonatorlänge.

10. Laserstrahlungsquelle nach einem der Ansprüche 1 bis 9, bei der die obere und die untere metallische Schicht (5, 6) aus Kupfer besteht.

11. Laserstrahlungsquelle nach Anspruch 10, bei der die mindestens eine elektrisch isolierende Schicht (7) aus einer Aluminiumnitrid-Keramik besteht.

12. Laserstrahlungsquelle nach Anspruch 11, bei der die Summe der Dicken der metallischen Schichten (5, 6) aus Kupfer doppelt so groß ist wie die Summe der Dicken der nichtmetallischen Schichten (7) aus Aluminiumnitrid-Keramik.

13. Laserstrahlungsquelle nach Anspruch 11, bei der die Summe der Dicken der metallischen Schichten (5, 6) aus Kupfer zu der Summe der Dicken der nichtmetallischen Schichten (7) aus Aluminiumnitrid-Keramik Verhältnisse von 1,5:1 bis 2,0:1 bei Vickershärten des Kupfers von HV60 bis HV120 annimmt.

14. Laserstrahlungsquelle nach einem der Ansprüche 1 bis 13, bei der der Träger (4') mit einem zwischen nichtmetallischen Schichten (16, 17) angeordneten Mikrokühler (18) ausgestattet ist, der Kanäle für ein Kühlmedium aufweist, für das ein Zufuhrkanal (19) und ein Ableitungskanal (20) im Boden des Trägers (4') vorgesehen sind.
